# EUROPÄISCHE PATENTANMELDUNG

(11) **EP 2 570 946 A1**
(43) Veröffentlichungstag der Anmeldung: **20.03.2013**
(21) Anmeldenummer: 11191163.2
(22) Anmeldetag: 29.11.2011
(51) Int. Cl.: G06F 17/50, H01L 31/042, G06Q 10/04

(54) **Verfahren und Vorrichtung zum Erstellen einer Konfiguration einer Solarzellentischanordnung mit einer Vielzahl von Solarzellentischen für ein Photovoltaik-Freiflächenkraftwerk**

(30) Priorität: 16.09.2011 DE 102011082848
(71) Anmelder: Siemens Aktiengesellschaft, 80333 München (DE)
(72) Erfinder: Bauer, Petra, 80797 München (DE); Fige, Peter, 80687 München (DE); Fink, Rafael, 81829 München (DE)

(57) **Zusammenfassung**

Verfahren und Vorrichtung zum Erstellen einer Konfiguration einer Solarzellentischanordnung mit einer Vielzahl von Solarzellentischen für ein Photovoltaik-Freiflächenkraftwerk

Die Erfindung betrifft ein Verfahren und eine Vorrichtung zum Erstellen einer Konfiguration einer Solarzellentischanordnung mit einer Vielzahl von Solarzellentischen für ein Photovoltaik-Freiflächenkraftwerk mit den folgenden Schritten: Bereitstellen von Daten zur Geländetopologie und/oder von Daten zu einer Lage eines für die Solarzellentischanordnung vorgesehenen Geländes und von Daten zu Kraftwerkskomponenten, welche für die Solarzellentischanordnung vorgesehen werden, und Berechnen der Konfiguration der Solarzellentischanordnung des Photovoltaik-Freiflächenkraftwerks anhand der bereitgestellten Daten zur Verortung der Kraftwerkskomponenten sowie anhand einer dynamischen Programmierung auf der Basis eines Schätzwertes für die Anzahl platzierter Solarzellentische.

## Beschreibung

Verfahren und Vorrichtung zum Erstellen einer Konfiguration einer Solarzellentischanordnung mit einer Vielzahl von Solarzellentischen für ein Photovoltaik-Freiflächenkraftwerk

### Technisches Gebiet

Die Erfindung betrifft ein Verfahren und eine Vorrichtung zum Erstellen einer Konfiguration einer Solarzellentischanordnung mit einer Vielzahl von Solarzellentischen für ein Photovoltaik-Freiflächenkraftwerk.

### Stand der Technik

Die standortbezogene Projektierung und Einrichtung von Photovoltaik-Freiflächenkraftwerken stellt bei herkömmlichen Entwicklungsverfahren einen Engpass dar. Das Layout von Photovoltaik-Anlagen wird bei herkömmlichen Entwicklungsverfahren für jede Anlage individuell mit Hilfe einer Tabellenkalkulations-basierten, von Experten manuell durchgeführten Planung entworfen oder vollumfänglich von einem Planer erstellt.

Diese herkömmlichen Verfahren sind sehr zeitintensiv und wegen der enormen Datenmenge auch fehleranfällig. Aufgrund der sich von Anlage zu Anlage stets ändernden Voraussetzungen, wie beispielsweise Umriss und Topologie des zu beplanenden Geländes, regionale Reglementierungen oder ähnliches, ist es nicht möglich, bereits entworfene Photovoltaik-Freiflächenkraftwerke bei der Planung anderer Anlagen wiederzuverwenden oder anzupassen, so dass für jede Anlage eine umfassende, eigenständige Planung durchzuführen ist.

In der für eine Angebotserstellung erforderlichen Grobplanung von Anlagen bleiben wegen der häufig knappen Ausschreibungsdauer im Allgemeinen wichtige Aspekte, wie z.B. die Topologie des Geländes, unberücksichtigt. Dies bedeutet im Hinblick auf die in dem Angebot gemachten Zusagen natürlich einen großen Unsicherheitsfaktor.

Eine Software-technische Unterstützung haben die Planer bisher lediglich bei der Wahl gewisser Konfigurationsparameter erhalten. Beispielswiese sind Software-Tools bekannt, mit deren Hilfe die Abhängigkeit der Leistung eines Photovoltaik-Freiflächenkraftwerks von Sonneneinstrahlungsdaten und von der Lage des zu beplanenden Geländes des Photovoltaik-Freiflächenkraftwerks ermittelt werden kann.

Die DE 199 50 676 A1 beschreibt ein Verfahren zur graphischen Darstellung des zeitlichen Verlaufs der Sonneneinstrahlung an einem bestimmten Ort und zu einer bestimmten Zeit. Bei dem dort beschriebenen Verfahren wird die auf der der Sonne zugewandten Seite eines bestimmten Ortes befindliche Umgebung mit Hilfe einer Kamera von dem Ort aus aufgenommen und als Abbildung wiedergegeben, wobei bei der Aufnahme der vertikale Aufnahmewinkel und der horizontale Aufnahmewinkel und der Azimut der Aufnahmerichtung gemessen und festgehalten wird.

Bei dem dort beschriebenen Verfahren zur graphischen Darstellung des zeitlichen Verlaufs der Sonneneinstrahlung wird die geographische Lage des Ortes bestimmt und für diese Ortslage wird die Sonnenbahn oder die scheinbare Laufbahn der Sonne um die Erde am Himmel, eine Ekliptik, für einen bestimmten Kalendertag errechnet. Die errechnete Sonnenbahn wird sodann als sichtbare Linie entsprechend der gemessenen Aufnahmedaten in die Abbildung eingetragen.

Die DE 20314665U1 beschreibt eine Anordnung zur flächigen Abdeckung von Geländeerhebungen, wie Schüttgut- oder Abraumhalden, Schallschutzwälle oder Hochwasserdämme oder sonstiger Freiflächen mit einer zumindest teilweise geneigten und/oder gekrümmten Oberfläche, wobei eine Tragkonstruktion zur Aufnahme von Abdeckelementen vorgesehen ist, die mit wenigstens einem Abdeckelement bestückt ist, welche in einem Abstand zur Oberfläche der Geländeerhebung angeordnet sind und die Oberfläche der Geländeerhebung zumindest teilweise überdecken.

Es ist daher eine Aufgabe der vorliegenden Erfindung, ein Verfahren und eine Vorrichtung zu schaffen, welches nach Maßgabe von Designregeln eine Projektierung und eine Einrichtung eines Photovoltaik-Freiflächenkraftwerks auf der Basis von spezifizierten Kraftwerks- und Geländedaten ermöglicht.

Diese Aufgabe wird erfindungsgemäß durch ein Verfahren mit den im Patentanspruch 1 angegebenen Merkmalen sowie durch eine Vorrichtung mit den Merkmalen gemäß Patentanspruch 14 gelöst.

Die Erfindung schafft demnach ein Verfahren zum Erstellen einer Konfiguration einer Solarzellentischanordnung mit einer Vielzahl von Solarzellentischen für ein Photovoltaik-Freiflächenkraftwerk mit den folgenden Schritten: Bereitstellen von Daten zur Geländetopologie und/oder von Daten zu einer Lage eines für die Solarzellentischanordnung vorgesehenen Geländes und von Daten zu Kraftwerkskomponenten, welche für die Solarzellentischanordnung vorgesehen werden, und Berechnen der Konfiguration der Solarzellentischanordnung des Photovoltaik-Freiflächenkraftwerks anhand der bereitgestellten Daten zur Verortung der Kraftwerkskomponenten sowie anhand einer dynamischen Programmierung auf der Basis eines Schätzwertes für die Anzahl platzierter Solarzellentische.

Eine der Erfindung zugrundeliegende Idee liegt darin, dass das erfindungsgemäße Verfahren zunächst ein Anlagenlayout einer Konfiguration einer Solarzellentischanordnung bestimmt. Das Anlagenlayout umfasst eine Platzierung von Solarzellentischen mit den Photovoltaikmodulen, eine Verortung von Kabelwegen und Servicewege, eine Platzierung von Wechselrichtern und Anschlusskästen, eine Zuordnung der Solarzellentische zu den einzelnen Wechselrichtern, eine Kabelführung sowie eine Auswahl von Kabelquerschnitten und eine Modulsortierung. Durch die dynamische Programmierung können auf der Basis eines Schätzwertes für die Anzahl platzierter Solarzellentische simultan eine Solarzellentischspalten-Wege-Konfiguration sowie deren Verortung in Ost-West-Richtung berechnet werden, so dass die Schätzfunktion für die Anzahl platzierter Solarzellentische maximiert wird. Das der dynamischen Programmierung zugrunde liegende Bellmansche Optimalitätsprinzip kann darüber hinaus auch bei der Verortung der Tischreihen in Nord-Süd-Richtung verwendet werden, so dass das durch den Geländeumriss gegebene Platzangebot unter Berücksichtigung der Designregeln und der Geländetopologie bestmöglich zur Platzierung von Solarzellentischen ausgenutzt werden kann.

Das vollständige Optimierungsproblem des erfindungsgemäßen Verfahrens weist eine hohe Komplexität auf und wird daher durch einen hierarchischen Ansatz, d.h. eine Dekomposition der Aufgabenstellung, gelöst. Selbst die durch die Dekomposition entstehenden Einzelprobleme sind teilweise schwierig zu lösen und erfordern das Bereitstellen spezialisierter und komplexer Berechnungsverfahren.

Die Aufgabenstellung des erfindungsgemäßen Verfahrens umfasst auch allgemein gültige Designregeln sowie durch den jeweiligen Anlagenplaner für die aktuell zu planende Anlage gewählte Designparameter und durch den jeweiligen Anlagenplaner für die aktuell zu planende Anlage spezifizierte Eingabedaten.

Unter Designregeln werden zum einen schaltungstechnische oder physikalische Nebenbedingungen, die eingehalten werden müssen, und zum anderen sonstige Regeln verstanden, die im Hinblick auf eine Standardisierung des Anlagenlayouts oder zur Steigerung der Anlageneffizienz festgelegt wurden.

Die Optimierungsaufgabe liegt in der Berechnung eines hinsichtlich Nennleistung, Effizienz und Kosten optimierten Anlagenlayouts unter Berücksichtigung der Designregeln, in kurzer Zeit, d.h. innerhalb weniger Minuten.

Bei einer möglichen Ausführungsform des erfindungsgemäßen Verfahrens wird als ein Parameter für die Berechnung einer Solarzellentischspalten-Wege-Konfiguration zunächst die Anzahl an Kabel- und Servicewegen und an Solarzellentischspalten bestimmt.

Bei einer möglichen Ausführungsform des erfindungsgemäßen Verfahrens wird für jede mögliche Verortung der Solarzellentischspalten in West-Ost-Richtung ein Spaltenschätzwert berechnet, der angibt, wie viele Solarzellentische in jeder einzelnen Solarzellentischspalte verortet werden können.

Bei einer Ausführungsform des erfindungsgemäßen Verfahrens wird durch die Bestimmung der Solarzellentischspalten-Wege-Konfiguration und deren Verortung in West-Ost-Richtung auf der Basis der Spaltenschätzwerte aller Solarzellentischspalten für die Anzahl an platzierten Solarzellentischen ein Aufteilen des Geländes in Teilbereiche vorgenommen.

Bei einer Ausführungsform des erfindungsgemäßen Verfahrens werden unter Berücksichtigung von Designregeln und von Daten zur Geländetopologie in den einzelnen Teilbereichen des Geländes zwischen je zwei in Nord-Süd-Richtung verlaufenden benachbarten Kabel- und Servicewegen Solarzellentischreihen verortet. Ein Vorteil liegt hierbei in einer verbesserten Optimierung des Anlagenlayouts des Photovoltaik-Freiflächenkraftwerks.

Bei einer möglichen Ausführungsform des erfindungsgemäßen Verfahrens wird die Maximierung der Anzahl der Solarzellentische des Photovoltaik-Freiflächenkraftwerks innerhalb der Teilbereiche zwischen je zwei in Nord-Süd-Richtung verlaufenden Kabel- und Servicewegen durch eine Optimierung einer Nord-Süd-Koordinate der Solarzellentische erreicht, zum Beispiel mit Hilfe einer dynamischen Programmierung.

Bei einer alternativen Ausführungsform des erfindungsgemäßen Verfahrens umfasst das Erstellen der Konfiguration der Solarzellentischanordnung eine Prüfung der Kompatibilität der vorgesehenen Kraftwerkskomponenten zueinander.

Bei einer Ausführungsform des erfindungsgemäßen Verfahrens werden Daten zur Geländetopologie durch eine Interpolation von Höhendaten mittels einer Triangulation erzeugt. Dies erlaubt auch ein unzugängliches Gelände zu beplanen, welches nur teilweise oder nur unzureichend vermessen werden kann.

Bei einer möglichen Ausführungsform des erfindungsgemäßen Verfahrens wird zur Durchführung des Verfahrens ein Optimierungsmodul mit mehreren Algorithmen verwendet, welches mehrere Berechnungsverfahren benutzt, die zur Projektierung und zur Einrichtung des Photovoltaik-Freiflächenkraftwerks verwendet werden.

Bei einer möglichen Ausführungsform des erfindungsgemäßen Verfahrens wird zur Durchführung des Verfahrens ein Benutzeroberflächenmodul verwendet, welches als graphische Benutzeroberfläche ausgelegt wird und/oder Funktionalitäten zur Dateneingabe und/oder zur Datenverwaltung und/oder zur Datenausgabe aufweist und/oder zum Aufruf des Optimierungsmoduls und/oder zur Ergebnisdarstellung ausgelegt ist.

Bei einer möglichen Ausführungsform des erfindungsgemäßen Verfahrens wird mindestens einer der Algorithmen des Optimierungsmoduls dazu ausgelegt, mit einer Zielfunktion eine Maximierung einer Anzahl von Solarzellentischen des Photovoltaik-Freiflächenkraftwerks zu erreichen.

Bei einer möglichen Ausführungsform des erfindungsgemäßen Verfahrens wird mindestens einer der Algorithmen des Optimierungsmoduls dazu ausgelegt, mit einer Zielfunktion eine Minimierung einer Anzahl von Wechselrichter-Containern des Photovoltaik-Freiflächenkraftwerks zu erreichen.

Bei einer möglichen Ausführungsform des erfindungsgemäßen Verfahrens wird mindestens einer der Algorithmen des Optimierungsmoduls dazu ausgelegt, mit einer Zielfunktion eine Minimierung einer Summe aller Distanzen zwischen Wechselrichter-Containern des Photovoltaik-Freiflächenkraftwerks und den ihnen zugeordneten Solarzellentischen zu erreichen.

Die Erfindung schafft ferner eine Vorrichtung zum Erstellen einer Konfiguration einer Solarzellentischanordnung mit einer Vielzahl von Solarzellentischen für ein Photovoltaik-Freiflächenkraftwerk, wobei die Vorrichtung ein Optimierungsmodul aufweist, welches dazu ausgelegt ist, Daten zur Geländetopologie und/oder Daten zu einer Lage eines für die Solarzellentischanordnung vorgesehenen Geländes und Daten zu Kraftwerkskomponenten bereitzustellen, welche für die Solarzellentischanordnung vorgesehen werden, und anhand der bereitgestellten Daten sowie anhand einer dynamischen Programmierung auf der Basis eines Schätzwertes für die Anzahl platzierter Solarzellentische eine Konfiguration der Solarzellentischanordnung des Photovoltaik-Freiflächenkraftwerks zu berechnen.

Im Weiteren werden mögliche Ausführungsformen des erfindungsgemäßen Verfahrens und der erfindungsgemäßen Vorrichtung unter Bezugnahme auf die beigefügten Figuren beschrieben.

Es zeigen:
- Fig. 1: eine Darstellung eines Ablaufdiagramms einer möglichen Ausführungsform des erfindungsgemäßen Verfahrens;
- Fig. 2A: eine Darstellung eines Benutzeroberflächenmoduls zur Dateneingabe gemäß einer möglichen Ausführungsform der erfindungsgemäßen Vorrichtung;
- Fig. 2B: eine Darstellung einer Kartenansicht eines für ein Photovoltaik-Freiflächenkraftwerk zu beplanendes Geländes gemäß einer möglichen Ausführungsform des erfindungsgemäßen Verfahrens;

- Fig. 3A: eine Darstellung einer Verschaltung von Photovoltaikmodulen eines Solarzellentischs eines Photovoltaik-Freiflächenkraftwerkes gemäß einer möglichen Ausführungsform des erfindungsgemäßen Verfahrens;
- Fig. 3B: eine Darstellung eines Benutzeroberflächenmoduls zur Dateneingabe von Daten zur Geländetopologie gemäß einer möglichen Ausführungsform der erfindungsgemäßen Vorrichtung;
- Fig. 3C: eine Darstellung möglicher Auswirkungen der Geländetopologie auf die Platzierung der Solarzellentische gemäß einer möglichen Ausführungsform der erfindungsgemäßen Vorrichtung;
- Fig. 4: eine Darstellung einer Anordnung von Solarzellentischspalten eines Photovoltaik-Freiflächenkraftwerkes gemäß einer möglichen Ausführungsform des erfindungsgemäßen Verfahrens;
- Fig. 5: eine Seitenansicht zweier Solarzellentische eines Photovoltaik-Freiflächenkraftwerkes zur Illustration von Neigungs- und Schattenwinkel gemäß einer möglichen Ausführungsform des erfindungsgemäßen Verfahrens;
- Fig. 6: eine Darstellung eines Detailausschnitts eines möglichen Anlagenlayouts, auf dem Generatorkästen, Koppelkästen und Verbindungskabel gemäß einer möglichen Ausführungsform des erfindungsgemäßen Verfahrens abgebildet sind;
- Fig. 7: eine Darstellung einer Konfiguration einer Solarzellentischanordnung für ein einfaches annähernd rechtwinkeliges Gebiet gemäß einer möglichen Ausführungsform des erfindungsgemäßen Verfahrens;

- Fig. 8-11: jeweils einen Detailausschnitt eines möglichen Anlagenlayouts einer Konfiguration einer Solarzellentischanordnung gemäß einer möglichen Ausführungsform des erfindungsgemäßen Verfahrens;
- Fig. 12: eine Darstellung eines Anlagenlayouts eines Photovoltaik-Freiflächenkraftwerkes gemäß einer möglichen Ausführungsform des erfindungsgemäßen Verfahrens; und
- Fig. 13: ein Ablaufdiagramm eines Algorithmus zur Projektierung und zur Einrichtung des Photovoltaik-Freiflächenkraftwerks gemäß einer möglichen Ausführungsform des erfindungsgemäßen Verfahrens.

In den Figuren der Zeichnung bezeichnen gleiche Bezugszeichen gleiche oder funktionsgleiche Komponenten oder Verfahrensschritte, soweit nichts Gegenteiliges angegeben ist.

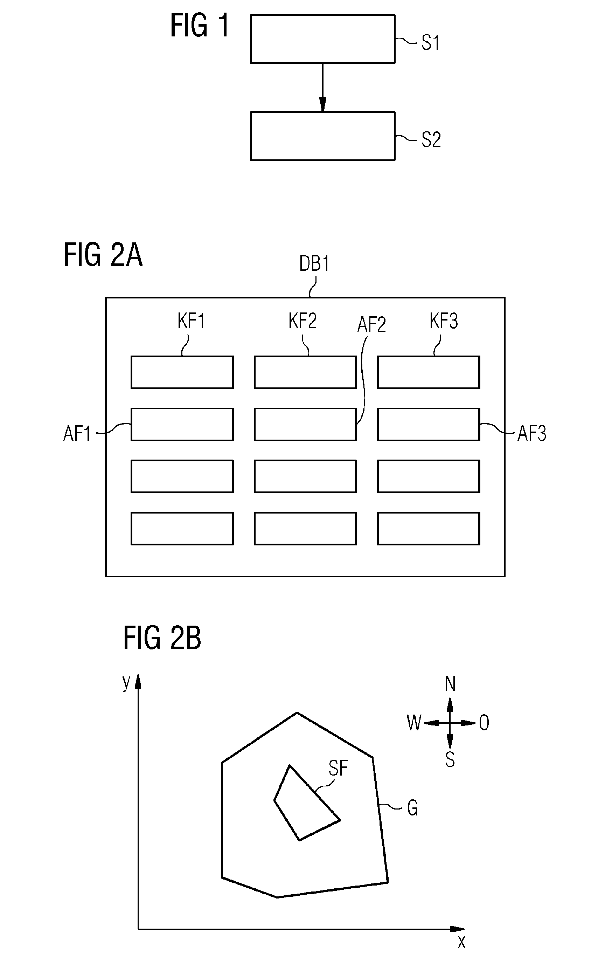

Die Figur 1 zeigt eine Darstellung eines Ablaufdiagramms einer möglichen Ausführungsform des erfindungsgemäßen Verfahrens.

In einem ersten Schritt S1 des Verfahrens erfolgt ein Bereitstellen von Daten zur Geländetopologie und/oder von Daten zu einer Lage eines für die Solarzellentischanordnung vorgesehenen Geländes und von Daten zu Kraftwerkskomponenten, welche für die Solarzellentischanordnung vorgesehen werden.

Die Daten zur Geländetopologie umfassen beispielsweise ein digitales Höhenmodell, ein digitales Geländemodell oder ein sonstiges Modell mit einem Datenbestand zur höhenmäßigen Beschreibung des zu beplanenden Geländes. Die Daten zur Geländetopologie umfassen regelmäßig oder unregelmäßig in einem Raster verteilte Geländepunkte, die die Höhenstruktur des Geländes hinreichend repräsentieren.

Kraftwerkskomponenten sind beispielsweise Wechselrichter, Photovoltaikmodule, Solarzellenstrings, Solarzellentische, Kabel zur Verbindung, Kopplungskästen, Anschlusskästen oder Wechselrichter-Container oder sonstige elektrische Modulkomponenten.

In einem zweiten Schritt S2 des Verfahrens erfolgt ein Berechnen der Konfiguration der Solarzellentischanordnung des Photovoltaik-Freiflächenkraftwerks anhand der bereitgestellten Daten zur Verortung der Kraftwerkskomponenten sowie anhand einer dynamischen Programmierung auf der Basis eines Schätzwertes für die Anzahl platzierter Solarzellentische.

Die bereitgestellten Daten umfassen beispielsweise auch schaltungstechnische Nebenbedingungen oder sonstige Normbedingungen oder Sicherheitsrichtlinien des Photovoltaik-Freiflächenkraftwerks. Als schaltungstechnische Nebenbedingungen sind beispielsweise Platzierungsnebenbedingungen oder Nebenbedingungen zu elektrischen Größen von Kraftwerkskomponenten wie elektrische Maximal-Stromstärken oder elektrische Spannungen vorgesehen.

Die Figur 2A zeigt beispielhaft eine Darstellung eines Benutzeroberflächenmoduls zur Dateneingabe gemäß einer möglichen Ausführungsform der erfindungsgemäßen Vorrichtung.

Beispielsweise werden als Dialogfenster oder Dialogfelder oder Dialogboxen spezielle Fenster in einer grafischen oder zeichenorientierten Benutzerschnittstelle DB1 definiert und aufgezeigt.

Beispielsweise umfasst die Benutzerschnittstelle DB1 eine Vielzahl von Dialogfenster, welche formularartig aufgebaut sind und zur Eingabe von Daten vorgesehen sind. Dazu werden beispielsweise Standard-Widgets wie Textfelder KF1-KF3 und Checkboxes AF1-AF3 verwendet.

Beispielhaft wird die Verwaltung der Modultypdaten und ein Geländedateninputdialog gezeigt.

Der Geländedateninputdialog ermöglicht die Definition von Gelände- und Sperrflächenumrissen sowie von den Höhendaten für das Gelände G.

Ein weiteres Menü bietet Funktionalitäten zur Geländedaten- und Equipmentauswahl sowie zur Parametereingabe. Außerdem werden beispielsweise Informationen, etwa zu den Ergebnissen einer physikalischen oder schaltungstechnischen Prüfung der Solarzellentischanordnung, dargestellt.

Beispielsweise wird nach Anklicken eines Buttons ein Optimierungslauf gestartet und eine Optimierungsseite wird geöffnet. Es erscheint eine Kurzinformation zum aktuell von dem Optimierungsmodul bearbeiteten Optimierungsauftrag sowie eine Statusanzeige, die über den Programmfortschritt Auskunft gibt.

Nach Beendigung des Optimierungslaufs erscheint eine Kurzzusammenfassung der Ergebnisse. Durch Anklicken eines weiteren Buttons werden die Ergebnisse im Detail aufbereitet. Nach Beendigung der Ergebnisaufbereitung öffnet sich die Reportseite. Die Optimierungsergebnisse können in Form einer Graphik mit Interaktions- und Zoomfunktion oder als Ergebnis- oder Datenlisten angezeigt werden.

Die Figur 2B zeigt beispielhaft eine Darstellung einer Kartenansicht eines für ein Photovoltaik-Freiflächenkraftwerk zu beplanenden Geländes gemäß einer möglichen Ausführungsform des erfindungsgemäßen Verfahrens.

Beispielsweise können durch eine Festlegung von konkreten Werten für Designparameter die Designregeln konkretisiert werden. Eingabedaten spezifizieren beispielsweise die zu planende Anlage oder das Anlagenlayout des Photovoltaik-Freiflächenkraftwerks.

In einem Gelände G, das durch seinen Umriss, seine Höhendaten und eventuell eine - wie vorliegend in Figur 2B gezeigt - oder mehrere vorhandene Sperrflächen SF definiert ist, wird ein Photovoltaik-Freiflächenkraftwerk oder eine Photovoltaikanlage aufgestellt, wobei die Solarzellentischanordnung nach Nennleistung und/oder nach Kosten und/oder nach Effizienz optimiert wird.

Das zu beplanende Gelände G ist in der abgebildeten Ausrichtung dargestellt. Die West-Ost-Ausrichtung, W-O, ist durch die x-Koordinate gegeben, die Nord-Süd-Ausrichtung, N-S, durch die y-Koordinate.

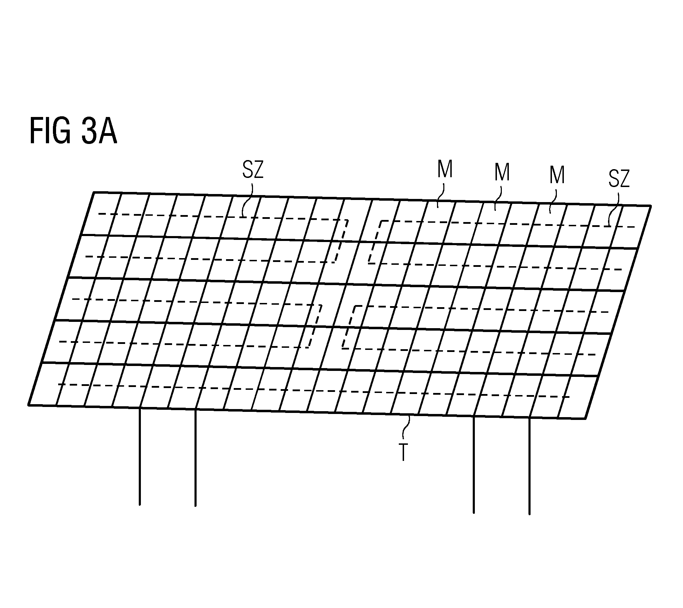

Die Figur 3A zeigt eine Darstellung einer Verschaltung von Photovoltaikmodulen M eines Solarzellentischs T eines Photovoltaik-Freiflächenkraftwerkes gemäß einer möglichen Ausführungsform des erfindungsgemäßen Verfahrens.

Beispielsweise wird eine Verschaltung von mehreren gleichartigen Photovoltaikmodulen M zu so genannten Solarzellenstrings SZ in Reihe auf einem Solarzellentisch T vorgenommen. Die Solarzellenstrings SZ werden so an die Wechselrichtereingänge angeschlossen.

Welche Anzahl von Photovoltaikmodulen M in einem Solarzellenstring SZ realisiert wird, hängt von den Wechselrichterdaten ab. Für die Planung eines konkreten Anlagenlayouts ist beispielsweise die Anzahl der Photovoltaikmodule M pro Solarzellenstring SZ oder auch die Zahl der Solarzellenstrings SZ auf einem Solarzellentisch T vorgegeben.

Die Figur 3A zeigt exemplarisch einen Solarzellentisch T mit darauf montierten Photovoltaikmodulen M. Die gestrichelten Linien deuten die Verschaltung der Solarzellenstrings SZ an. Beispielsweise ist im vorliegenden Fall eine Anzahl von fünf Solarzellenstrings SZ mit jeweils 20 Photovoltaikmodulen M vorgesehen.

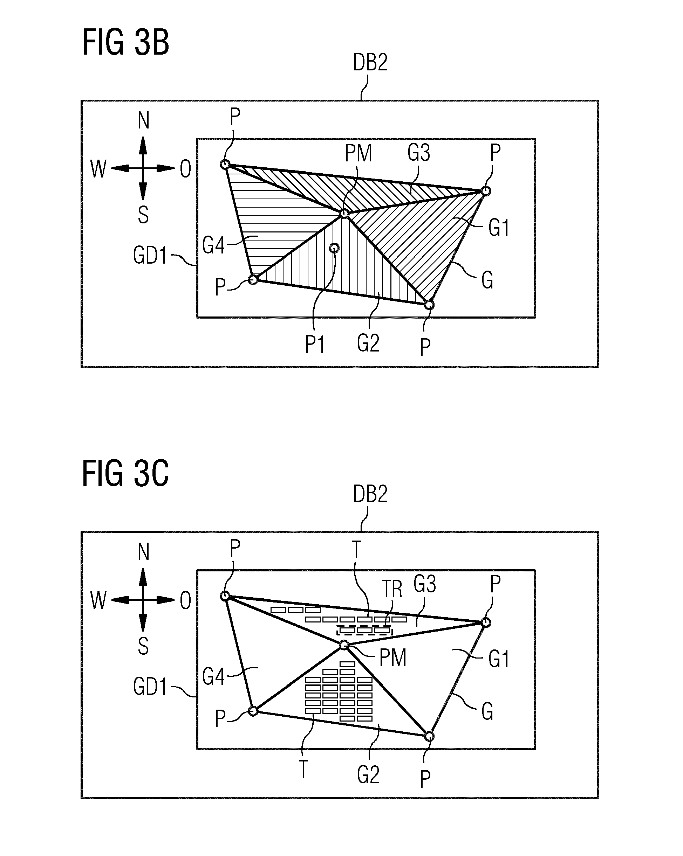

Die Figur 3B zeigt eine Darstellung eines Benutzeroberflächenmoduls zur Dateneingabe von Daten zur Geländetopologie gemäß einer möglichen Ausführungsform der erfindungsgemäßen Vorrichtung.

Das Benutzeroberflächenmodul weist ein Menü DB2 mit einer Geländedialogbox GD1 eines Planungstools auf und bietet darüber hinaus die erforderlichen Funktionalitäten zur Eingabe und Verwaltung der Grunddaten, wie beispielsweise Daten zu Modultypen der Photovoltaikmodule M, Daten zu den verwendeten Typen der Wechselrichter oder Daten zu dem Gelände G und gegebenenfalls weitere Daten.

Das Gelände G umfasst beispielsweise, wie in Figur 3B dargestellt, vier Geländeteilbereiche G1-G4.

Die vier Geländeteilbereiche G1-G4 bilden Dreiecke mit gemeinsamen Eckpunkten, welche als Geländepunkte P dargestellt sind. Einer der Eckpunkte der Dreiecke des Dreiecksnetzes ist als Geländepunkt PM dargestellt. Der Geländepunkt PM bildet eine Bergspitze eines Berges, welcher die vier Geländeteilbereiche G1-G4 als Hangflächen des Berges umfasst.

Die vier Geländeteilbereiche G1-G4 bilden somit ein das Gelände G abbildendes Dreiecksnetz umfassend die Geländepunkte P, PM. Auf Basis dieses Dreiecksnetzes kann nun beispielsweise mittels eines Triangulationsverfahrens ein weiterer Geländepunkt P1 berechnet werden, ohne eine vorhergehende Messung des Geländepunktes P1 vornehmen zu müssen, im Gegensatz zu den durch Messung ermittelten Geländepunkten P und PM.

Die Figur 3C zeigt eine Darstellung möglicher Auswirkungen der Geländetopologie auf die Platzierung der Solarzellentische gemäß einer möglichen Ausführungsform der erfindungsgemäßen Vorrichtung.

Beispielhaft ist eine Anordnung von Solarzellentischen T eines Photovoltaik-Freiflächenkraftwerkes gezeigt, wie sie unter Berücksichtigung der in Figur 3B beschriebenen Topologie ermittelt wird. Die Geländeteilbereiche G2 und G3 des Geländes G bilden beispielsweise Hangflächen des den Geländepunkt PM als Bergspitze aufweisenden Berges. Die Hangflächen des Berges haben dabei jeweils unterschiedliche Hangneigungen, welche die jeweiligen Neigungswinkel zwischen einer Hangfläche und dem Geoid - in guter Näherung der mittlere Meeresspiegel der Weltmeere - aufweisen.

Die jeweilige Hangneigung der Hangflächen wiederum beeinflusst den unter Berücksichtigung des vorgegebenen Schattenwinkels errechneten Abstand d zwischen nebeneinander liegenden Modulreihen der Solarzellentische T, d.h. zwischen den Solarzellentischreihen TR, in den Geländeteilbereichen G2 und G3.

Wie in der Figur 3C dargestellt ergibt sich für eine ermittelte Konfiguration der Solarzellentischanordnung in den Geländeteilbereiche G2 und G3 jeweils ein unterschiedlicher Abstand d zwischen zwei in Nord-Süd-Richtung benachbarten Solarzellentischreihen TR. Dieser unterschiedliche Reihenabstand der Konfiguration der Solarzellentischanordnung in den Geländeteilbereiche G2 und G3 ist durch die unterschiedliche Hangneigung, d.h. der Geländetopologie in Nord-Süd-Richtung, der beiden Geländeteilbereiche G2 und G3 des Geländes G begründet.

Um die gewünschte Effizienz der Konfiguration der Solarzellentischanordnung zu erreichen, wird nun unter Berücksichtigung des hierfür vorgegebenen Schattenwinkels in dem Geländebereich G3, welcher einen Nordhang darstellt, ein größerer Reihenstand zwischen zwei in Nord-Süd-Richtung benachbarten Solarzellentischreihen TR als in dem Geländebereich G2 ermittelt, welcher als Südhang eine geringere Tendenz zur gegenseitigen Verschattung der dort angeordneten Solarzellentische T aufweist.

Die weiteren in der Figur 3C verwendeten Bezugszeichen sind bereits in der Figurenbeschreibung der Figur 3B erläutert, infolgedessen wird auf eine weitere Beschreibung der in der Figur 3C ferner vorhandenen Bezugszeichen verzichtet.

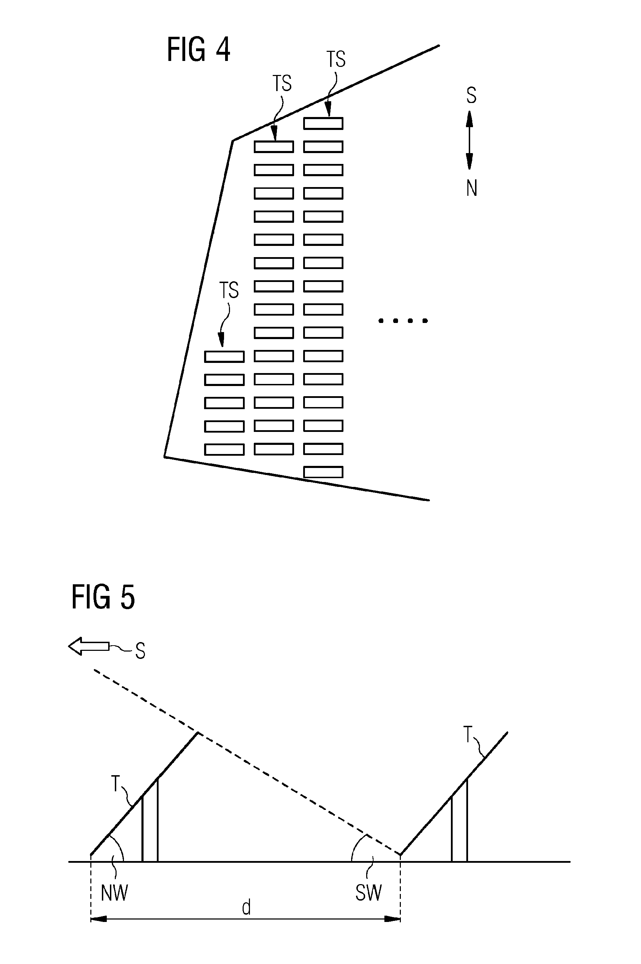

Die Figur 4 zeigt eine Darstellung einer Anordnung von Solarzellentischspalten TS eines Photovoltaik-Freiflächenkraftwerkes gemäß einer möglichen Ausführungsform des erfindungsgemäßen Verfahrens.

Die Solarzellentische T werden spaltenweise in Solarzellentischspalten TS nebeneinander aufgestellt. Die Solarzellentischspalten TS verlaufen jeweils von Süd (S) nach Nord (N). Durch einen mit N und S bezeichneten Doppelpfeil wird in Figur 4 eine entsprechende geographische Bezugsrichtung zu den Solarzellentischspalten TS in der Zeichnung definiert.

Bei dem erfindungsgemäßen Verfahren kann beispielsweise angegeben werden, ob neben ganzen Solarzellentischen T auch halbe Solarzellentische T oder sogar Viertelsolarzellentische erlaubt sind, um das gegebene Gelände G durch das Photovoltaik-Freiflächenkraftwerk besser nutzen zu können.

Die Halb- bzw. Viertelsolarzellentische T können beispielsweise anschließend an die Platzierung zu ganzen Solarzellentischen T gruppiert werden, wobei nur, in bestimmtem Sinne, benachbarte Solarzellentische T derselben Gruppe zugeordnet werden können.

Die Figur 5 zeigt eine Seitenansicht zweier Solarzellentische T eines Photovoltaik-Freiflächenkraftwerkes zur Illustration von Neigungs- und Schattenwinkel, die bei einer möglichen Ausführungsform des erfindungsgemäßen Verfahrens verwendet werden.

Die Solarzellentische T haben nach Süden S hin einen festen Neigungswinkel NW, der von der geographischen Lage und Beschaffenheit des Geländes G abhängt und beispielsweise von einem Planer einzugeben ist. Der Planer einer Anlage bzw. eines Photovoltaik-Freiflächenkraftwerkes definiert ferner beispielsweise einen Schattenwinkel SW, der angibt, ab welchem Sonnenhöhenwinkel die Solarzellentische T der Anlage sich nicht mehr selbst verschatten dürfen. Der Schattenwinkel SW kann auch berechnet werden.

Der Schattenwinkel SW bezeichnet den Winkel der Sonne, bei dem eine vordere Modulreihe der Solarzellentische T gerade noch nicht eine dahinter liegende Modulreihe von Solarzellentischen T verschattet.

Die vordere Modulreihe der Solarzellentische T ist in der Figur 5 durch den südlicheren der beiden dort dargestellten Solarzellentische T definiert. Die hintere Modulreihe der Solarzellentische T ist in der Figur 5 durch den nördlicheren der beiden dargestellten Solarzellentische T definiert.

Ein kleiner Schattenwinkel SW erhöht den relativen Solarertrag des Photovoltaik-Freiflächenkraftwerkes pro Solarzellentisch T, während ein größerer Schattenwinkel SW eine bessere Nutzung bzw. Ausnutzung der Geländefläche durch eine dichtere Solarzellentisch-Belegung des zu beplanenden Geländes erlaubt.

Aus dem Schattenwinkel SW, der Geländetopologie des Geländes G und einer Designregel, die einen Minimalabstand zwischen nebeneinander liegenden Modulreihen fordert, ergibt sich beispielsweise, welchen Abstand d zwei in Nord-Süd-Richtung benachbarte Solarzellentische T haben müssen. Dieser Abstand d wird als Reihenabstand bezeichnet und kann für verschiedene Solarzellentischreihen TR der Anlage variieren.

In Ost-West-Richtung kann zwischen den Solarzellentischen T ein im Vergleich zu dem Abstand d kleinerer Abstand gewahrt werden, der von dem Planer zu spezifizieren ist und für die ganze Anlage fix ist.

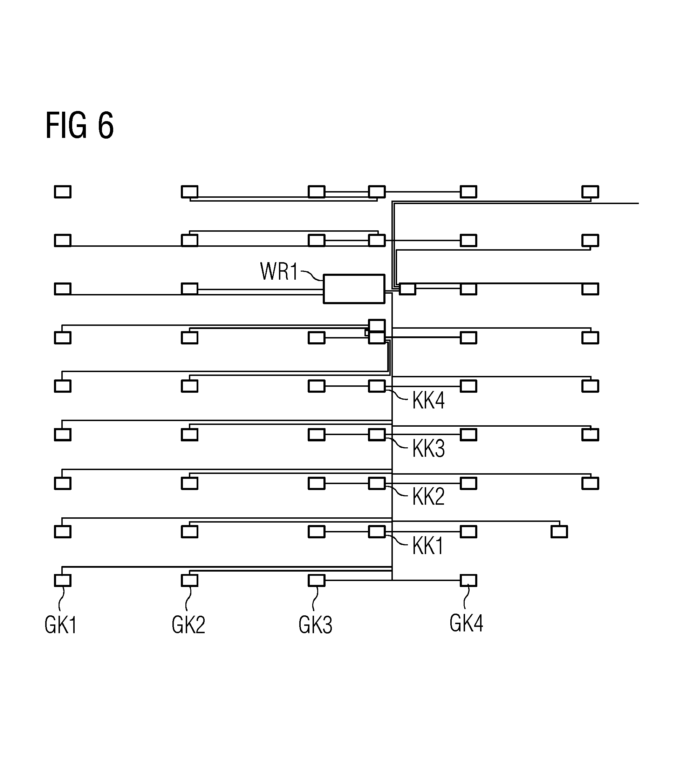

Die Figur 6 zeigt eine Darstellung eines Detailausschnitts eines möglichen Anlagenlayouts, auf dem Generatoranschlusskästen, Koppelkästen und Verbindungskabel gemäß einer möglichen Ausführungsform des erfindungsgemäßen Verfahrens abgebildet sind.

Die Generatoranschlusskästen GK1-GK4 verschalten einen oder mehrere Solarzellenstrings SZ der zugeordneten Solarzellentische T und bündeln so die von den zugehörigen Photovoltaikmodulen M erzeugte elektrische Leistung.

Die Generatoranschlusskästen GK1-GK4 wiederum werden über den Koppelkasten KK1 mit dem Wechselrichter WR1 verbunden.

Der Koppelkasten KK1 bündelt dabei, wie in Figur 6 gezeigt, mehrere Generatorkästen GK1-GK4. Die Koppelkästen KK1-KK4 verschalten die Generatorkästen GK1-GK4 und die weiteren gezeigten jedoch nicht mit einem Bezugszeichen versehenen Generatorkästen miteinander und leiten die elektrische Energie zu dem Wechselrichter WR1. Der Wechselrichter WR1 wandelt den die elektrische Energie übertragenden Gleich- in einen Wechselstrom um. Anschließend wird die elektrische Energie in ein Stromnetz eingespeist. Beispielsweise ist der Wechselrichter WR1 in einem Wechselrichter-Container WC1 verortet.

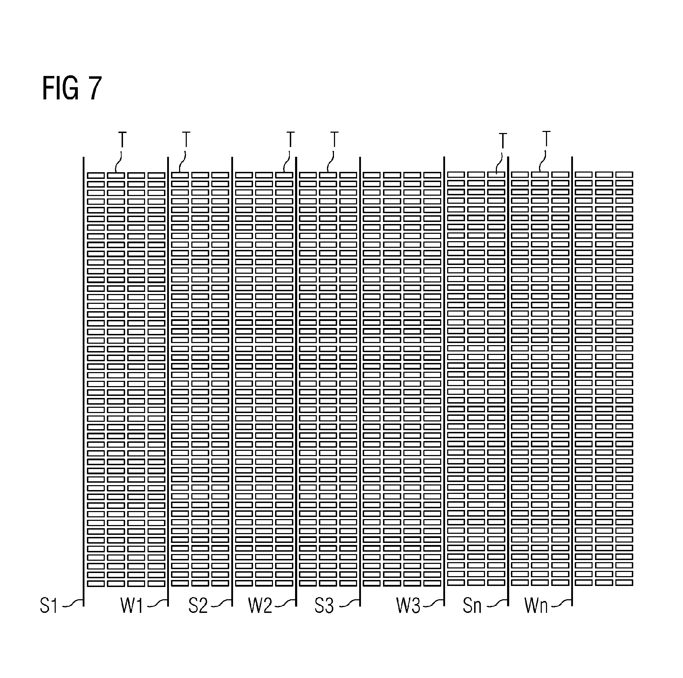

Die Figur 7 zeigt eine Darstellung einer Konfiguration einer Solarzellentischanordnung für ein einfaches annähernd rechtwinkeliges Gebiet gemäß einer möglichen Ausführungsform des erfindungsgemäßen Verfahrens.

Die Solarzellentischanordnung umfasst eine Vielzahl von Solarzellentischen T für ein Photovoltaik-Freiflächenkraftwerk. Kabel zur Verschaltung des Kraftwerkequiments, die in Nord-Süd-Richtung verlaufen, werden jeweils in einem der Kabelwege W1-Wn geführt. Die Solarzellentische T sind über die Servicewege S1-Sn zugänglich. Dabei sind die Servicewege S1-S4 jeweils zwischen den Kabelwegen W1-W4 verortet. Sowohl die Kabelwege W1-W4 als auch die Servicewege S1-S4 verlaufen in Nord-Süd-Richtung.

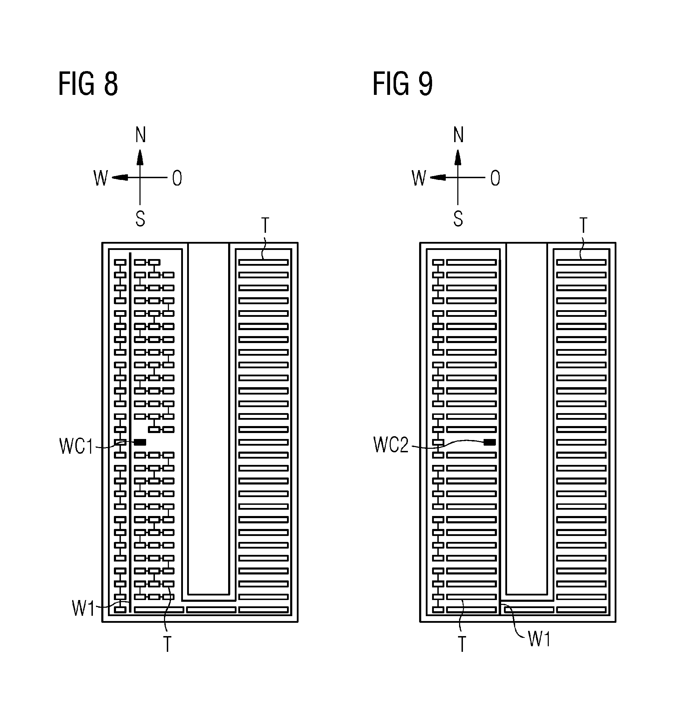

Die Figuren 8-11 zeigen jeweils einen Detailausschnitt eines möglichen Anlagenlayouts einer Konfiguration einer Solarzellentischanordnung gemäß einer möglichen Ausführungsform des erfindungsgemäßen Verfahrens. In den Figuren 8-11 werden Sperrflächen SF des Geländes G jeweils mit schwarzem Farbton gekennzeichnet.

In der Figur 8 ist an dem Kabelweg W1 ein Wechselrichtercontainer WC1 bzw. ein Container WC1 verortet, welcher an eine Vielzahl von fraktionierten Solarzellentischen T gekoppelt ist. Beispielsweise ist die komplette linke Geländehälfte, welche sich in östlicher Richtung von dem Kabelweg W1 befindet, nur mit fraktionierten Solarzellentischen T belegt.

Durch die simultane Berechnung einer Solarzellentischspalten-Wege-Konfiguration und deren Verortung in West-Ost-Richtung kann dies, wie in Figur 9 gezeigt, vermieden werden. In der Figur 9 ist der Kabelweg W1 an einer anderen Stelle verortet worden. Durch die simultane Berechnung einer Solarzellentischspalten-Wege-Konfiguration und deren Verortung in West-Ost-Richtung verläuft der Kabelweg W1 unmittelbar am rechten Rand des linken Geländeabschnitts. Dies erlaubt eine Platzierung von mehr ganzen Solarzellentischen T auf dem Gelände.

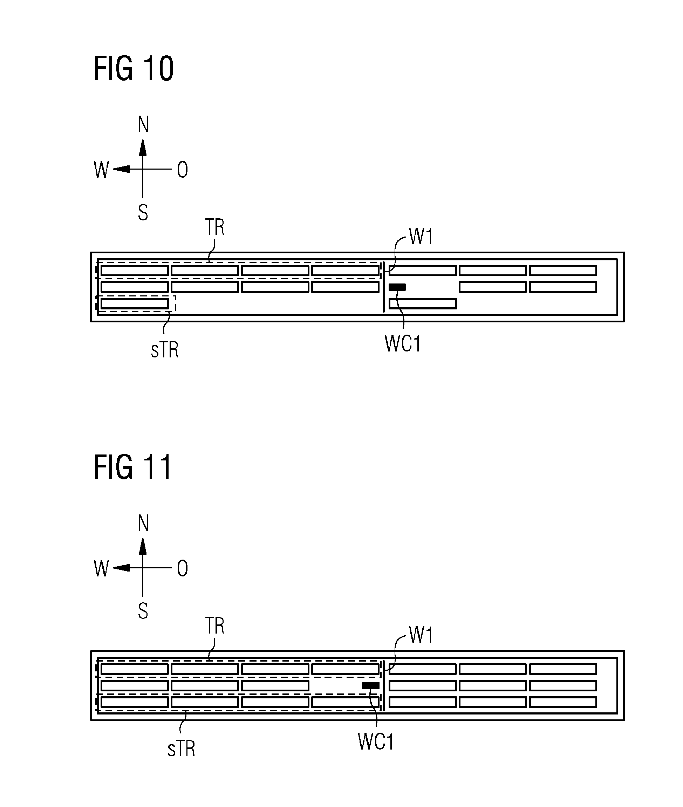

In den Figuren 10 und 11 ist jeweils an dem Kabelweg W1 ein Wechselrichtercontainer WC1 verortet bzw. platziert. Die Konfiguration der Solarzellentischanordnung wurde jedoch auf Grundlage von unterschiedlichen Verfahren vorgenommen. In dem Gelände G verläuft die südliche Geländegrenze in dem dargestellten Beispiel in einer leichten Schräge, also nicht parallel zur West-Ost-Achse.

Bei der in der Figur 10 gezeigten Konfiguration der Solarzellentischanordnung wird ein Verfahren durchgeführt, bei welchem mit einer ersten, südlichsten Tischreihe sTR der Solarzellentische T so südlich wie möglich begonnen wird, so dass aufgrund der Schräge in der ersten, südlichsten Tischreihe sTR jeweils nur ein einziger Solarzellentisch T platziert werden kann.

Bei der in der Figur 11 gezeigten Konfiguration der Solarzellentischanordnung wurden die Solarzellentische mittels einer dynamischen Programmierung platziert, so dass der Algorithmus erkennt, dass es bei diesem Gelände vorteilhaft ist, die südlichste Solarzellentischreihe sTR der Konfiguration nicht an einer möglichst südlich liegenden Position zu verorten, sondern die südlichste Solarzellentischreihe sTR in einer im Vergleich zur südlichsten Position etwas weiter nördlicheren Position zu verorten.

Diese Konfiguration der Solarzellentischanordnung, wie sie in Figur 11 gezeigt ist, ermöglicht, auch in der südlichsten Tischreihe sTR eine voll besetzte Tischreihe TR zu verorten, ohne bei der nördlichsten Tischreihe Kapazitäten zu verlieren.

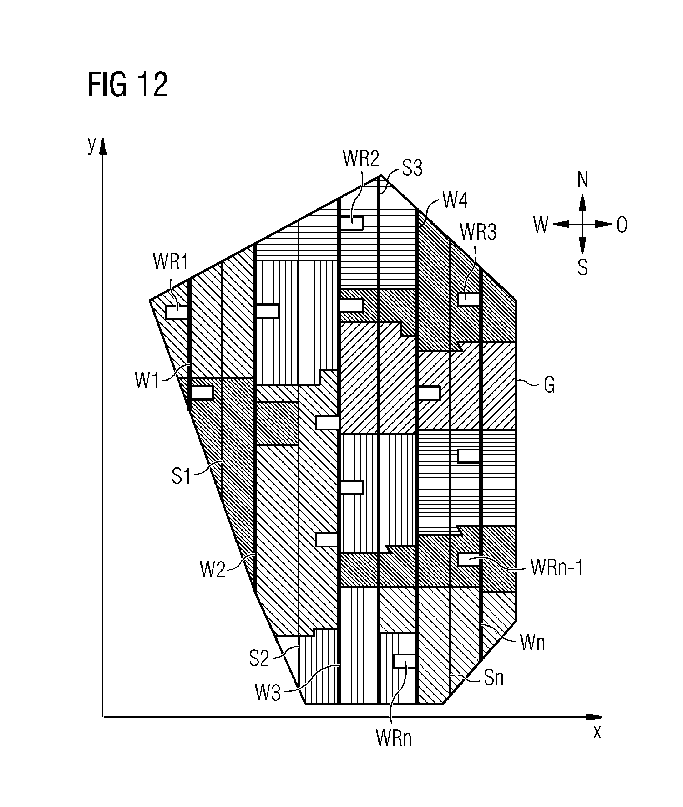

Die Figur 12 zeigt eine Darstellung eines Anlagenlayouts eines Photovoltaik-Freiflächenkraftwerkes gemäß einer möglichen Ausführungsform des erfindungsgemäßen Verfahrens.

Das zu beplanende Gelände G, auf welchem das Photovoltaik-Freiflächenkraftwerk errichtet wird, ist in der abgebildeten Ausrichtung in der Figur 12 dargestellt. Die Ost-West-Ausrichtung, O-W, ist durch die x-Koordinate gegeben, die Süd-Nord-Ausrichtung, N-S, durch die y-Koordinate. Das Gelände G ist mit den darin platzierten Kabel- und Servicewegen W1-Wn, S1-Sn sowie den Solarzellentischen T und Wechselrichtern WR1-WRn dargestellt.

Gleichstromseitig sind als wesentliche Komponenten einer Photovoltaikanlage Photovoltaikmodule M, Solarzellentische T und Wechselrichter WR1-WRn vorgesehen.

Die Photovoltaikmodule M produzieren unter Einstrahlung von Sonnenlicht Gleichstrom. Auf den Solarzellentischen T werden die Photovoltaikmodule M montiert. Die Wechselrichter WR1-WRn wandeln den von den Photovoltaikmodule M erzeugten Gleichstrom in für Stromnetze vorteilhaft geeigneten Wechselstrom um.

Ferner umfasst eine Photovoltaikanlage eine Vielzahl von Kabeln, die die Photovoltaikmodule M untereinander verschalten, sowie an den jeweiligen Wechselrichter WR1-WRn anschließende Generatorkästen GK1-GKn oder Koppelkästen KK1-KKn.

Auf dem Gelände G müssen Kabel- und Servicewege W1-Wn, S1-Sn oder Fahrwege verortet werden. Die Kabelwege W1-Wn verlaufen von Nord nach Süd, die Servicewege S1-Sn verlaufen ebenfalls von Nord nach Süd mit Ausnahme eines umlaufenden Serviceweges, der das gesamte Gelände G umschließen kann. Die Kabelwege W1-Wn dienen zur Verortung von in Nord-Süd-Richtung verlaufenden Kabeln, mit welchen die die Kraftwerkskomponenten des Photovoltaik-Freiflächenkraftwerkes verschaltet werden. Die Solarzellentische T sind über die Servicewege S1 - Sn zugänglich.

Zahl und Typen der auf dem Gelände G aufzustellenden Wechselrichter WR1-WRn sind beispielsweise von den Leistungen der verfügbaren Wechselrichter WR1 - WRn abhängig, oder von der Gesamtnennleistung der Photovoltaikanlage, die sich wiederum aus der Anzahl der untergebrachten Photovoltaikmodule M errechnet, sowie von der Geländetopologie des Geländes G abhängig ist.

Ein jeder der Wechselrichter WR1 - WRn hat mehrere Gleichstrom-Eingänge, an die mehrere parallel geschaltete Solarzellenstrings SZ angeschlossen werden. Die Anzahl der an einen Wechselrichtereingang anzuschließenden Solarzellenstrings SZ ergibt sich aus den Moduldaten der Photovoltaikmodule M, aus den Wechselrichterdaten der Wechselrichter WR1-WRn und den Designparametern der Photovoltaikanlage und ist innerhalb eines bestimmten Bereichs flexibel.

Jedem Wechselrichter WR1-WRn wird ein Teil des Geländes G zugeordnet, wie es durch unterschiedliche Schraffuren des Geländes G dargestellt ist. Die auf dem jeweiligen Geländeteil befindlichen Solarzellenstrings SZ werden an den jeweiligen Wechselrichter WR1-WRn angeschlossen.

Um die Verkabelung des Photovoltaik-Freiflächenkraftwerkes zu vereinfachen und Material bei der Einrichtung der Photovoltaikanlage zu sparen, werden beispielsweise die Kabel mehrerer Solarzellenstrings SZ in einem Generatoranschlusskasten GK gebündelt. Analog werden beispielsweise die Verbindungskabel mehrerer Generatorkästen GK1 - GKn der Photovoltaikanlage in einem sogenannten Koppelkasten KK1 - KKn zusammengeführt. Jeder Koppelkasten KKn wird dann auf einen Gleichstrom-Eingang eines Wechselrichters WRn geleitet.

Die Verkabelung ist sowohl aus logischer Sicht als auch aus physikalischer und schaltungstechnischer Sicht, beispielsweise hinsichtlich einer exakten Kabelführung, zu betrachten.

Außerdem sind die Kabelquerschnitte der Kabel unter Berücksichtigung der elektrischen Verluste zu bestimmen. Im Zusammenhang mit den Kabelverlusten ist auch das Problem der Modulsortierung zu beachten. Werden in einer Photovoltaikanlage Photovoltaikmodultypen mit unterschiedlichen elektrischen Daten verwendet, so ist eine im Hinblick auf die möglichst gleichmäßige Auslastung der Wechselrichtereingänge günstige Verteilung der Photovoltaikmodule M auf das Photovoltaik-Feld zu bestimmen.

Beispielsweise wird zur Projektierung des Konfigurationsmusters eine Platzierung der Kabel- und Servicewege W1-Wn, S1-Sn sowie der Solarzellentische T im Gelände unter Maximierung der Solarzellentischanzahl vorgenommen.

Ist die Zahl der Solarzellentischspalten TS und die Zahl der Kabel- und Servicewege W1-Wn, S1 - Sn gegeben, so ist beispielsweise die optimale Konfiguration der Solarzellentischspalten TS und die Konfiguration der Wege sowie die Verortung dieses Solarzellentischspalten-Wege-Konfigurationsmusters in West-Ost-Richtung im Rahmen der Freiheitsgrade zu bestimmen. Dies kann Beispielsweise auf der Grundlage eines Schätzwertes für die Anzahl an platzierten Solarzellentischen mittels einer dynamischen Programmierung simultan geschehen.

Freiheitsgrade sind dabei die x-Koordinate der ersten, beispielsweise der westlichsten Solarzellentischspalte TS und die Zahl der Solarzellentischspalten TS vor dem ersten oder nach dem letzten Kabelweg sowie die Zahl der Solarzellentischspalten TS zwischen den einzelnen Kabel- und Servicewegen W1-Wn, S1 - Sn.

Zur Verortung der Solarzellentischreihen innerhalb der durch die Solarzellentischspalten-Wege-Konfiguration definierten Geländeteilbereiche zwischen je zwei in Nord-Süd-Richtung verlaufenden Wegen kann unter Berücksichtigung der Designregeln und der Geländetopologie beispielsweise ebenfalls eine dynamische Programmierung verwendet werden, um das durch den Geländeumriss und die Solarzellentischspalten-Wege-Konfiguration gegebene Platzangebot bestmöglich zur Platzierung von Solarzellentischen auszunutzen.

In einer weiteren Ausführungsform des erfindungsgemäßen Verfahrens wird eine Modulierung auf dem folgenden Input vorgenommen: Es werden Geländegrenzen einschließlich von möglichen Sperrflächen SF eingelesen. Ferner werden Solarzellentischdaten bezüglich einer Länge, einer Breite, einer Neigung, einer möglich Aufteilung der Solarzellentische T in Halbe- oder Vierteltische eingelesen.

Beispielsweise werden Pfaddaten bezüglich der Zahl der Kabel- und Servicewege W1 - Wn, S1 - Sn und/oder ihrer Breite eingelesen.

Dabei berücksichtigt das Verfahren beispielsweise die folgenden Restriktionen in Form von unterschiedlichen Designregeln: Designregeln für Kabel- und Servicewege W1-Wn, S1 - Sn und/oder Designregeln für Solarzellentische T oder Solarzellentischspalten TS oder Solarzellentischreihen TR und/oder Designregeln für Wechselrichtergebiete oder Wechselrichter-Container WC1-WCn.

Das Verfahren zum Erstellen der Konfiguration der Solarzellentischanordnung kann dabei beispielsweise in mehrere Optimierungsprobleme mit unterschiedlichen Zielfunktionen dekomponiert werden. Die einzelnen Optimierungsprobleme können sich dabei auf das gesamte für die Solarzellentischanordnung vorgesehene Gebiet beziehen oder nur auf bestimmte Teilbereiche. Teilbereiche können beispielsweise Wechselrichtergebiete oder Geländeteilbereiche zwischen zwei in Nord-Süd-Richtung verlaufenden Wegen sein oder durch sonstige Designregeln für das Gelände des Photovoltaik-Freiflächenkraftwerks vorgegeben werden.

Die Zielfunktionen der einzelnen Optimierungsprobleme können sich beispielsweise auf die Anzahl und/oder die Koordinaten der Solarzellentische T, der Solarzellentischspalten TS, der Wechselrichter WR1 - WRn, der Anschlusskästen oder andere Parameter des Layouts des Photovoltaik-Freiflächenkraftwerks beziehen.

Beispielsweise kann als Ziel eines Optimierungsproblems eine Maximierung der Zahl der Solarzellentische T, die in das Gelände G passen, angestrebt werden, wobei halbe bzw. viertel Solarzellentische T als halb bzw. als Viertel gezählt werden.

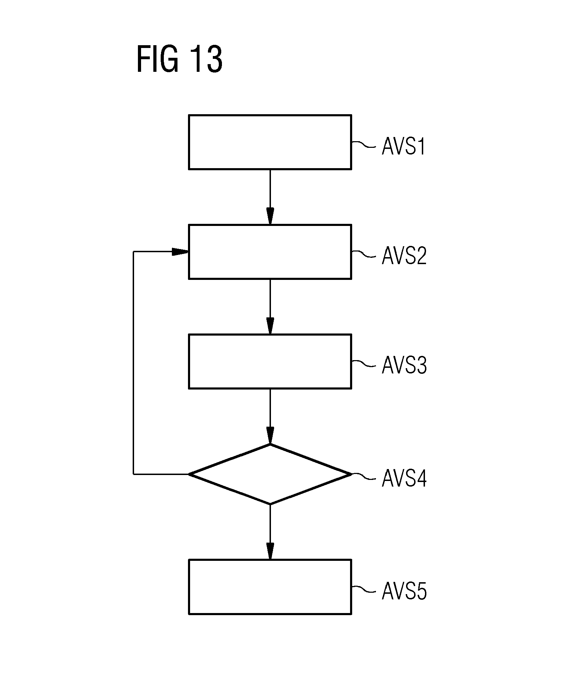

Die Figur 13 zeigt ein Ablaufdiagramm eines Algorithmus zur Projektierung und zur Einrichtung des Photovoltaik-Freiflächenkraftwerks gemäß einer möglichen Ausführungsform des erfindungsgemäßen Verfahrens.

Als erster Verfahrensschritt AVS1 werden für alle Solarzellentischpaare die zugehörigen Distanzen bei der Verkabelung ermittelt. Um die Kabelführung über Servicewege hinweg möglichst zu vermeiden, wird diese Distanz künstlich um einen Strafterm vergrößert, der proportional zur Anzahl an zu überquerenden Servicewegen ist.

In einem zweiten Verfahrensschritt AVS2 wird durch eine Initialisierung und mittels einer Greedy-Heuristik für jeden Wechselrichter-Container ein Solarzellentisch bestimmt, der bei der Initialisierung als Zentrum des zugehörigen Wechselrichtergebietes dient.

Anstelle dieser Greedy-Heuristik kann auch ein sonstiger Algorithmus verwendet werden, welcher schrittweise den Folgezustand auswählt, der zum Zeitpunkt der Wahl das beste Ergebnis verspricht.

Zielsetzung der Initialisierung ist es dabei, dass die minimale Distanz zwischen jedem Paar von Wechselrichtergebiets-Zentren maximiert wird.

Die Wechselrichtergebiete werden nun initialisiert, indem jedem Zentrum eines Wechselrichtergebietes weitere Solarzellentische T zugeordnet werden, und zwar so, dass die Summe aller Distanzen der Solarzellentische T zu den ihnen zugeordneten Zentren minimiert wird.

In einem dritten Verfahrensschritt AVS3 erfolgt eine Anpassung der zugeordneten Zentren der Wechselrichtergebiete.

In einem vierten Verfahrensschritt AVS4 wird der Wert dieser Zielfunktion mit einem vorbestimmten Wert verglichen und die Verfahrensschritte AVS2 und AVS3 gegebenenfalls wiederholt bis keine Verbesserung mehr auftritt.

In einem fünften Verfahrensschritt AVS5 werden die Position der Zentren der Wechselrichtergebiete und eine Wechselrichter-Tisch-Zuordnung ausgegeben.

## Patentansprüche

1. Verfahren zum Erstellen einer Konfiguration einer Solarzellentischanordnung mit einer Vielzahl von Solarzellentischen (T) für ein Photovoltaik-Freiflächenkraftwerk mit den folgenden Schritten:
- Bereitstellen (S1) von Daten zur Geländetopologie und/oder von Daten zu einer Lage eines für die Solarzellentischanordnung vorgesehenen Geländes (G) und von Daten zu Kraftwerkskomponenten, welche für die Solarzellentischanordnung vorgesehen werden; und
- Berechnen (S2) der Konfiguration der Solarzellentischanordnung des Photovoltaik-Freiflächenkraftwerks anhand der bereitgestellten Daten zur Verortung der Kraftwerkskomponenten sowie anhand einer dynamischen Programmierung auf der Basis eines Schätzwertes für die Anzahl platzierter Solarzellentische (T) .

2. Verfahren nach Anspruch 1,
wobei als ein Parameter für die Berechnung einer Solarzellentischspalten-Wege-Konfiguration zunächst die Anzahl an Kabel- und Servicewegen (W1-Wn, S1-Sn) und an Solarzellentischspalten (TS) bestimmt wird.

3. Verfahren nach einem der Ansprüche 1 oder 2,
wobei für jede mögliche Verortung der Solarzellentischspalten (TS) in West-Ost-Richtung ein Spaltenschätzwert berechnet wird, der angibt, wie viele Solarzellentische (T) in jeder einzelnen Solarzellentischspalte (TS) verortet werden können.

4. Verfahren nach einem der Ansprüche 2 bis 3,
wobei durch die Berechnung der Solarzellentischspalten-Wege-Konfiguration und deren Verortung in West-Ost-Richtung auf der Basis der Spaltenschätzwerte aller Solarzellentischspalten (TS) für die Anzahl an platzierten Solarzellentischen (T) ein Aufteilen des Geländes (G) in Teilbereiche vorgenommen wird.

5. Verfahren nach einem der Ansprüche 1 bis 4,
wobei unter Berücksichtigung von Designregeln und der Daten zur Geländetopologie in den einzelnen Teilbereichen des Geländes (G) zwischen je zwei in Nord-Süd-Richtung verlaufenden benachbarten Kabel- und Servicewegen (W1-Wn, S1-Sn) Solarzellentischreihen (TR) verortet werden.

6. Verfahren nach einem der Ansprüche 1 bis 5,
wobei eine Maximierung der Anzahl der Solarzellentische (T) des Photovoltaik-Freiflächenkraftwerks innerhalb der Teilbereiche zwischen je zwei in Nord-Süd-Richtung verlaufenden Kabel- und Servicewegen (W1-Wn, S1-Sn) durch eine Optimierung einer Nord-Süd-Koordinate der Solarzellentische (T) erreicht wird.

7. Verfahren nach einem der Ansprüche 1 bis 6,
wobei das Erstellen der Konfiguration der Solarzellentischanordnung eine Prüfung der Kompatibilität der vorgesehenen Kraftwerkskomponenten zueinander umfasst.

8. Verfahren nach einem der Ansprüche 1 bis 7,
wobei die Daten zur Geländetopologie durch eine Interpolation von Höhendaten mittels einer Triangulation erzeugt werden.

9. Verfahren nach einem der Ansprüche 1 bis 8,
wobei zur Durchführung des Verfahrens ein Optimierungsmodul mit mehreren Algorithmen verwendet wird, welches mehrere Berechnungsverfahren benutzt, die zur Projektierung und zur Einrichtung des Photovoltaik-Freiflächenkraftwerks verwendet werden.

10. Verfahren nach Anspruch 9,
wobei zur Durchführung des Verfahrens ein Benutzeroberflächenmodul verwendet wird, welches als graphische Benutzeroberfläche ausgelegt ist und/oder Funktionalitäten zur Dateneingabe und/oder zur Datenverwaltung und/oder zur Datenausgabe aufweist und/oder zum Aufruf des Optimierungsmoduls und/oder zur Ergebnisdarstellung ausgelegt ist.

11. Verfahren nach einem der Ansprüche 9 oder 10,
wobei mindestens einer der Algorithmen des Optimierungsmoduls dazu ausgelegt wird, mit einer Zielfunktion eine Maximierung einer Anzahl von Solarzellentischen (T) des Photovoltaik-Freiflächenkraftwerks zu erreichen.

12. Verfahren nach einem der Ansprüche 9 bis 11,
wobei mindestens einer der Algorithmen des Optimierungsmoduls dazu ausgelegt wird, mit einer Zielfunktion eine Minimierung einer Anzahl von Wechselrichter-Containern (WC1-WCn) des Photovoltaik-Freiflächenkraftwerks zu erreichen.

13. Verfahren nach einem der Ansprüche 9 bis 12,
wobei mindestens einer der Algorithmen des Optimierungsmoduls dazu ausgelegt wird, mit einer Zielfunktion eine Minimierung einer Summe aller Distanzen zwischen Wechselrichter-Containern (WC1-WCn) des Photovoltaik-Freiflächenkraftwerks und den ihnen zugeordneten Solarzellentischen (T) zu erreichen.

14. Vorrichtung zum Erstellen einer Konfiguration einer Solarzellentischanordnung mit einer Vielzahl von Solarzellentischen (T) für ein Photovoltaik-Freiflächenkraftwerk, wobei die Vorrichtung ein Optimierungsmodul aufweist, welches ausgelegt ist,
- Daten zur Geländetopologie und/oder Daten zu einer Lage eines für die Solarzellentischanordnung vorgesehenen Geländes und Daten zu Kraftwerkskomponenten bereitzustellen, welche für die Solarzellentischanordnung vorgesehen werden; und
- anhand der bereitgestellten Daten sowie anhand einer dynamischen Programmierung auf der Basis eines Schätzwertes für die Anzahl platzierter Solarzellentische (T) eine Konfiguration der Solarzellentischanordnung des Photovoltaik-Freiflächenkraftwerks zu berechnen.

15. Computerprogramm zur Durchführung des Verfahrens nach einem der Ansprüche 1-13.
